# EUROPEAN PATENT APPLICATION

(11) **EP 1 959 472 A2**
(43) Date of publication of application: **20.08.2008**
(21) Application number: 08101503.4
(22) Date of filing: 12.02.2008
(51) Int. Cl.: H01H 59/00

(54) **Power overlay structure for MEMS devices and method for making power overlay structure for MEMS devices**

(30) Priority: 13.02.2007 US 674189
(71) Applicant: General Electric Company, Schenectady, NY 12345 (US)
(72) Inventor: Arthur, Stephen Daley, Glenville, NY 12302 (US); Elasser, Ahmed, Latham, NY 12110 (US); Wright, Joshua Isaac, Arlington, VA 22201 (US); Subramanian, Kanakasabapthi, Clifton Park, NY 12065 (US); Keimel, Christopher Fred, Schenectady, NY 12309 (US); Gowda, Arun Virupaksha, Niskayuna, NY 12309 (US)
(74) Representative: Illingworth-Law, William Illingworth

(57) **Abstract**

One embodiment of the invention comprises a MEMS structure further comprising: a MEMS device (240) having a first surface with one or more contact structures (244, 245 and 246) thereon connected to functional elements of the MEMS device (240), a dielectric layer (100) overlying the first surface defining openings therein through which the contact structures (244, 245 and 246) are exposed, a patterned metallization layer (254, 255 and 256) comprising conductive material extending from the contact structures (244, 245 and 246) through the openings in the dielectric layer (100) and onto a surface of the dielectric layer and a first heat sink (190) in thermal communication with the metallization layer (254, 255 and 256).

## Description

### FIELD OF THE INVENTIONS

The embodiments of the present inventions relate generally to MEMS (micro-electrical-mechanical systems) and in particular to high current capacity MEMS devices.

### BACKGROUND OF THE INVENTIONS

Semiconductor devices, such as bipolar junction transistors (BJTs) and metal-oxide semiconductor field effect transistors (MOSFETs), are controllable to a substantially non-conductive state ("off," "open" or non-conducting) and to a substantially conductive state ("on," "closed" or conducting). Responsive to a control signal these devices are operable as a switch to connect and disconnect a load from a source. However, state-of-the-art transistors switches do not present ideal switch characteristics due to an off-state leakage current and an on-state resistance that dissipates power supplied by the source.

MEMS (microelectromechanical systems) devices comprise integrated micro-devices, such as mechanical components, formed on a substrate material. MEMS devices, which range in size from nanometers to millimeters, can sense, control, switch and actuate on a micro scale. A plurality of MEMS devices configured as an array can generate macro scale effects. Use of MEMS devices reduces the size and weight of mechanical and electrical systems compared with conventional mechanical systems. Electronic components may be formed on the same silicon chip as the mechanical MEMS device using integrated circuit processing techniques.

MEMS switches, which mimic operation of mechanical switches, are desired over semiconductor switches in certain applications. Unlike solid state switches that lack moving components, a MEMS switch physically opens and closes a circuit connected to switch contact points by movement of an actuator responsive to a control signal. Since actuator operation creates an air gap between the contact points, MEMS switches present high isolation (high impedance) and substantially zero leakage current in the open condition. Insertion loss in the closed condition is less than experienced with semiconductor switches.

MEMS switches also exhibit a more linear current response as a function of power and signal frequency than semiconductor switches.

Fabrication of MEMS devices employs processing steps similar to those utilized in the fabrication of integrated circuits. In particular, formation of the MEMS microstructures includes steps of depositing and patterning thin films on a substrate surface, such as a silicon wafer surface. Common thin film materials (applied with a thickness on the order of micrometers or less) and formed as layers or sublayers include, but are not limited to, silicon dioxide, silicon nitride, polycrystalline silicon, amorphous silicon, metals, metal alloys, carbon and silicides.

MEMS switches and relays operative in high input/output current applications are challenged by traditional semiconductor device interconnect and packaging approaches such as wire bonding, dual-in-line high-end packages, flip chips, etc. Both the input and output terminals of a high power/high current MEMS switch should be fabricated to withstand the current flow and the heat generated thereby. A conventional integrated circuit wire bond cannot successfully carry these high currents. Through-wafer vias utilized with MEMS devices in a flip-chip configuration also do not necessarily satisfy the high power requirements for certain MEMS switch applications.

The MEMS package should also provide a low resistance thermal conduction path from heat generating sites to an external surface where the heat can be removed from the device. Both steady state and transient heat sources should be considered. Inadequate heat removal can lead to micro melting of switch elements, shorting of the switch contact points and evaporation of switch elements, creating a permanent open circuit.

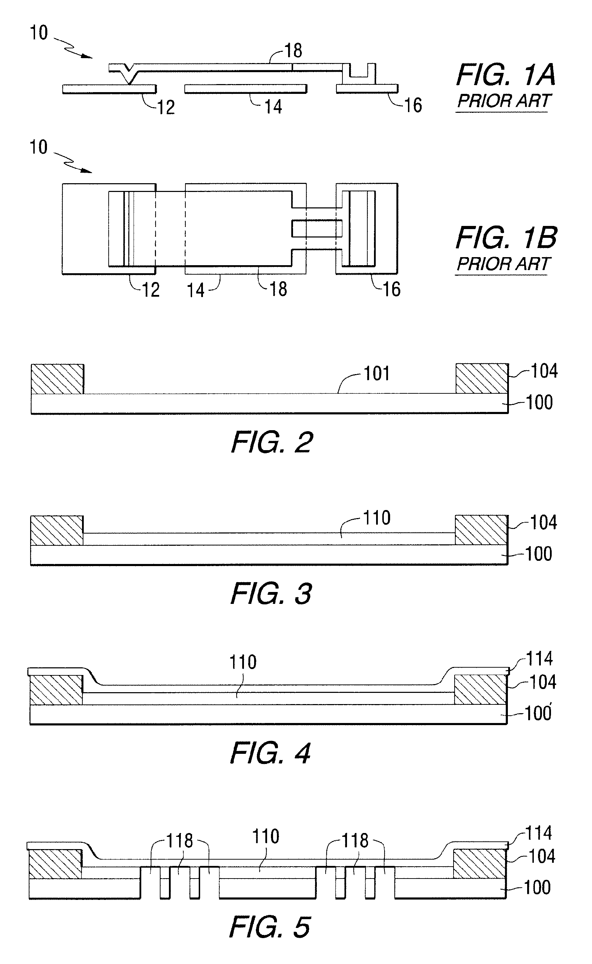

Figures 1A and 1B illustrate a prior art MEMS switch 10 comprising a drain 12, a gate 14 and a source 16 connected to a beam (cantilever) 18. Application of a voltage between the gate 14 and the source 16 generates an electrostatic force between the gate 14 and the beam 18, deforming the beam 18 into contact with the drain 12 to close the source/drain path. A size of a typical MEMS switch is about 100 microns by about 100 microns. Given the micro scale dimensions of the switch, a 10 mA typical current through the switch elements may result in a current density of as much as 1E8 A/m², since the effective contact area is about 10 microns by 10 microns (about 10% of the total contact area). When used in a high-current application, each switching element may be required to carry a current in the range of about 100 mA to 1A, resulting in a current density of about 1E9 A/m² to 1E10 A/m². In certain common switches the effective contact area is about 1 micron by 1 micron, resulting in a current density of about 1E10 A/m² for a 10 mA current.

Heat-induced failure modes of the MEMS switch 10 include sticking and friction forces, micro-welding and beam evaporation. Electrostatic and van der Wals forces can produce a permanent adhesion between the drain 12 and the beam 18, permanently retaining the switch in a closed position. In a micro-welding failure, a high electric field intensity across the gap between the drain 12 and the beam 18 causes the air gap to breakdown. The resulting electrical discharge permanently fuses the contacts. Micro-welding of the drain 12 and the beam 18 can also occur when a significant current flows through the closed switch elements. At high currents electromigration of the conductive elements may also reduce switch reliability. The likelihood of switch failure due to one or more of these failure modes increases as the switched current increases.

According to the prior art techniques, the MEMS switch 10 of Figures 1A and 1B is formed in a semiconductor substrate with conventional conductive vias carrying current (and heat) from the structural elements to a bond pad layer. In a wire bond packaging process bond wires connect each bond pad to a corresponding pad or conductive element at the next level of packaging, typically a printed circuit board. In a flip chip packaging process solder bumps are affixed to bond pads on the MEMS device body; these bumps are attached to a corresponding pad on the printed circuit board using a solder reflow process.

Disadvantageously, the bond wires add an undesirable inductance into the MEMS switch circuit. Further, neither the wire bond nor the flip chip schemes are capable of removing the substantial heat from the MEMS switch or carrying the switch currents when operated in a high-current application, especially in a high transient current load application.

### BRIEF DESCRIPTION OF THE INVENTIONS

One embodiment of the invention comprises a MEMS structure further comprising: a MEMS device having a first surface with one or more contact structures thereon connected to functional elements of the MEMS device, a dielectric layer overlying the first surface defining openings therein through which the contact structures are exposed, a patterned metallization layer comprising conductive material extending from the contact structures through the openings in the dielectric layer and onto a surface of the dielectric layer and a first heat sink in thermal communication with the metallization layer.

Another embodiment of the invention comprises a method for forming a MEMS structure, further comprising: providing a substrate having opposing first and second surfaces, forming an adhesive layer on the first surface of the substrate, forming openings through the substrate and the adhesive layer, affixing a MEMS device to the adhesive layer wherein each contact structure on a first surface of the MEMS device is aligned with one of the openings, forming conductive material on the second surface and into the openings and further in electrical contact with the contact structures and providing a first heat sink in thermal communication with the conductive material.

### BRIEF DESCRIPTION OF THE DRAWINGS

The present embodiments of the present inventions can be more easily understood and the advantages and uses thereof more readily apparent when the following detailed description of embodiments of the invention, provided by way of example only, is read in conjunction with the figures wherein:
Figures 1A and 1B are respective side and top views of a prior art MEMS switch.
Figures 2-11 are cross-sectional views taken along a common plane illustrating the results of sequential processing steps for forming a high current-carrying and high heat sinking package for MEMS structures according to various embodiments of the present invention.
Figure 12 is a cross-sectional view of a MEMS structure according to one embodiment of the invention.
Figures 13-24 are cross-sectional views taken along a common plane illustrating the results of sequential processing steps for forming a MEMS switch according to various embodiments of the present invention.
Figure 25 schematically illustrates a MEMS array according to one embodiment of the present invention.
In accordance with common practice, the various described features are not drawn to scale, but are drawn to emphasize specific features relevant to the embodiments of the inventions. Like reference characters denote like elements throughout the figures and text.

### DETAILED DESCRIPTION OF THE INVENTIONS

Before describing in detail MEMS devices and methods related to fabricating MEMS devices according to the embodiments of the present inventions, it should be observed that the embodiments reside in a novel and non-obvious combination of elements and process steps. So as not to obscure the disclosure with details that will be readily apparent to those skilled in the art, certain conventional elements and steps have been presented with lesser detail, while the drawings and the specification describe in greater detail other elements and steps pertinent to understanding the embodiments of the inventions. The illustrated process steps are merely exemplary, as one skilled in the art recognizes that certain independent steps illustrated below may be combined and certain steps may be separated into individual substeps to accommodate individual process variations.

The following embodiments are not intended to define limits as to the structures or methods of the inventions, but only to provide exemplary constructions. The embodiments are permissive rather than mandatory and illustrative rather than exhaustive.

In certain MEMS switch applications, such as a motor starter or a circuit breaker, it is desired that the MEMS switch elements and the interconnect system connecting the switch elements with external devices provide a high current capacity and successfully manage (remove or dissipate) the heat generated by current flow through the switch elements. It is further desired that the interconnect structures present a relatively low inductance and low electrical noise to avoid degrading switch operation. Connectability to standard wiring systems and packages, such as those conventionally used with integrated circuit technologies is also a desired feature. Low cost and reliable operation of the MEMS switch and the system into with which it operates are also desired MEMS switch attributes.

As applied to MEMS devices generally, the power overlay (POL) packaging and interconnect system of the embodiments of the present invention satisfy these requirements as it provides better thermal performance at a higher current capacity, especially during transient current spikes, than the interconnect systems of the prior art, such as wire bonding and flip chip interconnect techniques. The interconnect structures also present a relatively low inductance and low electromigration tendencies. The POL packaging and interconnect systems of the embodiments of the inventions offer an inductance that is lower than the inductance of wire bonds by about a factor of ten. The power overlay technique also conveniently and reliably integrates the interconnection of electronic components and MEMS devices. As applied to MEMS switches, the power overlay technique of the embodiments of the present inventions provides the desired high-current carrying capacity for the switch components.

According to the POL technique, the MEMS device is disposed on a dielectric substrate, comprising, for example, a polyimide film (for example Kapton). Openings aligned with the MEMS device contact pads are formed in the substrate. Depositing (e.g., by electroplating) copper (or another conductive material) into the substrate openings forms conductive vias in electrical communication with the device contacts. The interconnect techniques of the present inventions avoid troublesome solder joints or wire bonds. Use of a flexible dielectric substrate material, such as polyimide, provides an adaptable packaging system and technology that integrates easily with and accommodates other electronics devices and systems that may be used with the MEMS device. MEMS arrays comprising a plurality of individual MEMS devices, can also be fabricated according to these techniques.

The conductive (e.g., copper) vias are the primary path for heat flow from within the MEMS device. The heat flows from heat-generating elements within the MEMS device (package) through the conductive vias to an external heat sink having a high thermal conductivity (such as copper, aluminum or a composite material). Thus high currents can be supplied to and extracted from the MEMS device (e.g., a MEMS switch) through a packaging/interconnect system that tolerates the high input and output currents while providing adequate power dissipation for the heat generated by these currents.

In an embodiment where the heat sink is in contact with the conductive vias to remove heat from the MEMS device, the interface between the conductive vias and the heat sink must be thermally conductive and electrically non-conductive. Since a solid-solid interface is not desired for effective heat transfer, typically a thermal interface material is applied between the heat sink and the thermally conductive paths from the MEMS device. The interface material can also provide the necessary electrical isolation between the conductive vias and the heat sink. In one embodiment the interface material comprises a polymeric system, e.g., a silicone with a thermally conductive but electrically insulating filler.

Formation of the MEMS interconnect system according to one embodiment of the present inventions proceeds as follows. As illustrated in Figure 2, a polyimide film 100 is framed by a stainless steel frame 104. The film 100 is stretched and applied to the frame 104 using an adhesive. In one embodiment, the polyimide film 100 comprises a Kapton film having a thickness of about two mils. The exemplary frame 104 maintains the film 100 in a stable and flat configuration during the subsequent process steps.

A surface 101 of the polyimide film 100 undergoes a reactive ion etch to promote adhesion of a polymeric adhesive during the next processing step. The surface 101 is also scrubbed and an adhesive-promoting material applied thereto. The assembly comprising the film 100, the frame 104 and the adhesive promoting material is baked, in one embodiment at about 100° C for about 15 minutes.

A polymeric adhesive layer 110 is applied overlying the surface 101, as illustrated in Figure 3, by spin coating to a thickness of about 18 microns. The adhesive layer is partially cured by heating the assembly to about 70° C for about 15 minutes.

As illustrated in Figure 4, a protective film 114 having a thickness of about 12.5 microns is applied overlying the adhesive layer 110 and the frame 104 as illustrated in Figure 4. Openings or vias 118 are formed through the polyimide film 100 and the adhesive layer 110 as illustrated in Figure 5. In one embodiment the openings 118 are formed according to a laser ablation process while the protective film prevents the ablated material from redepositing on an exposed surface of the adhesive layer 110.

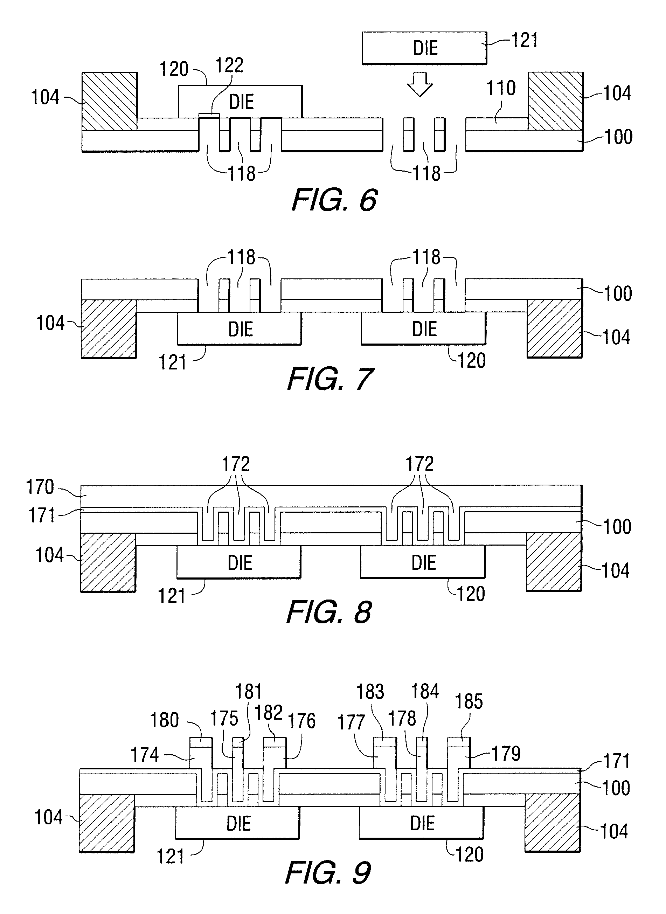

The protective film 114 is removed (by known mechanical processes) and as illustrated in Figure 6 a die 120 is disposed on the polymeric adhesive layer 110; a die 121 is illustrated in the process of placement onto the adhesive layer 110. The dies 120 and 121 can be placed automatically according to known processes, such as an automated pick and place process. A combination of the film 100, the frame 104 and the adhesive layer 110 is referred to as a carrier.

The dies 120 and 121 further comprise contact pads (an exemplary contact pad 122 is illustrated) on one or more external surface thereof; the contact pads are in electrical communication with functional components within each die 120 and 121. Thus during the placement process the contact pads are aligned with the via openings 118 for later electrical connection to other devices.

The carrier is baked at about 50° C for about 12 hours in a nitrogen atmosphere, followed by a pressure bake at about 190° C and 70 psi. These processes thermoset the adhesive 110 to ensure permanent adhesion of the dies 120 and 121 thereto.

The assembly is then scrubbed and reactive ion etched (to promote adhesion of a subsequently formed interconnect structure) followed by a cure at 200° C for about two hours in a nitrogen atmosphere.

As illustrated in Figure 7, the carrier is flipped and undergoes a reactive ion etch de-soot process and an adhesion promotion process. The carrier is further scrubbed and vacuum baked.

As illustrated in Figure 8, a metallization layer 170 is formed overlying the polyimide film 100, including conductive vias 172 in the openings 118. In an embodiment where the metallization layer comprises copper, prior to formation of the layer 170, preferably a titanium barrier layer having a thickness of about 1000 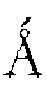 and a subsequent copper seed layer having a thickness of about 3000 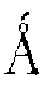 are sputtered within the via openings 118; the barrier and seed layers are identified by a reference character 171. Copper is electroplated within the openings 118 and overlaying the polyimide film 100 to form the metallization layer 170 and the conductive vias 172 that connect to the contact pads on the dies 120 and 121.

In other embodiments different metallization techniques can be employed to form the metallization layer 170 and the conductive vias 172.

The metallization layer 170 is patterned to form desired interconnect structures for electrically connecting the die contact pads to components in a system or subsystem operative with the MEMS devices. Known techniques to pattern the layer 170 include applying and developing a photoresist layer to form a mask followed by a subtractive etching process to remove regions of the layer 170 exposed through the mask.

Figure 9 illustrates the results of the metal patterning process including conductive structures 174-179 as well as overlying photoresist mask structures 180-185.

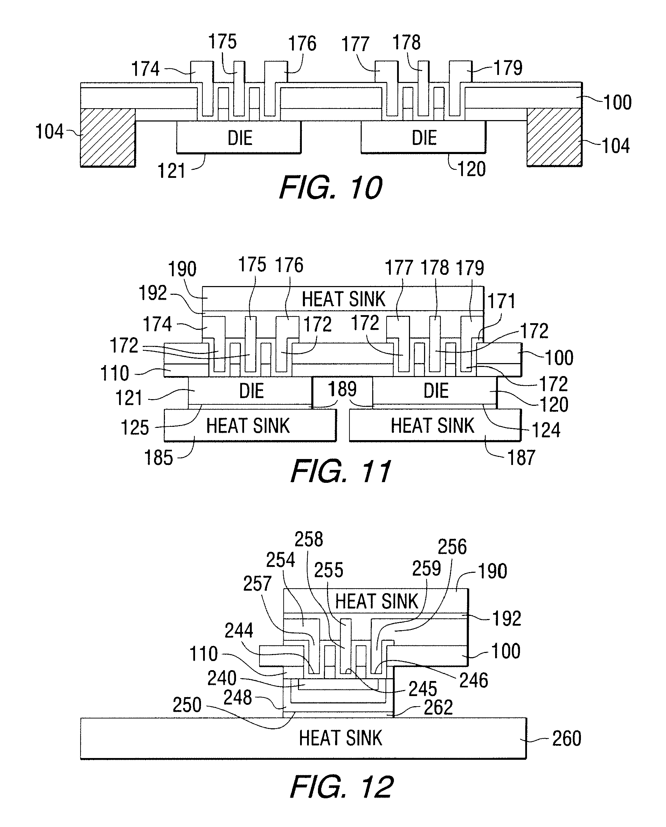

As illustrated in Figure 10, the photo resist mask structures 180-185 have been removed. Typically, the exposed conductive surfaces undergo metallization with electroless nickel to a thickness of about 1.3 microns followed by deposition of electroless gold to a thickness of about 1500 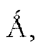 forming a surface that is suitable for soldering to a heat sink or interconnects of other devices. As is known in the art, solder masks (not shown) can be applied to exposed surfaces of the conductive structures 174-179 to define the solderable regions thereof and to protect the conductive structures 174-179 against oxidation.

As illustrated in Figure 11, the dies 120 and 121 and their connecting structures are singulated from the carrier to complete the fabrication process.

The electrically conductive paths of the die 120 and 121, i.e., the conductive vias 172 and the conductive structures 174-179 exhibit less inductance than the wire bonds of the prior art due to their shorter conductive paths and absence of conductive loops.

As can now be appreciated, the POL packing and interconnect systems of the embodiments of the present inventions comprises two thermal paths. Heat sinks 185 and 187 are disposed on respective surfaces 124 and 125 (see Figure 11) to remove heat from the dies 120 and 121. In one embodiment a thermal interface material 189 is disposed between the surfaces and 124 and 125 and the respective heat sink 185 and 187. In another embodiment a single heat sink replaces the two heat sinks 185 and 187.

In one embodiment a heat sink 190 and a thermal interface material 192 provide a thermal path to remove heat from the interconnect structures 174-179. can also be attached to an opposite surface of the structure (i.e. the surface of the conductive structures 174-179). The thermal interface material 192 tends to conform to the non-uniformities on the surface of the device (e.g., the regions between the conductive structures 174-179).

The prior art wire bonding approach cannot easily accommodate a heat sink on the conductive pad surface, since the fragile bond wires would interfere with the sink and prevent close thermal coupling between the heat sink and the device surface. Also, an opposite surface of the wire bonded device is typically attached to a substrate that has a relatively low thermal conductivity. Thus the prior art wire bonded device presents only one effective thermal path for removing heat from the device. The devices of the embodiments of the present inventions provide heat sinking paths on both major surfaces, thereby offering superior thermal management than the prior art wire bonding approach.

It is known that the currents in the devices of the dies 120 and 121 have both a steady state and a transient component. The transient component can be on the order of six to twelve times the steady state component for a duration of between about 50 milliseconds and 10 seconds. The considerable transient heat must be quickly and efficiently removed from the device to prevent damaging the device. In this scenario the POL approach of the embodiments of the invention provides significant advantages over the wire bond and flip chip prior art approaches, as the two heat paths of the POL devices provides faster heat removal.

Figure 12 illustrates a MEMS device 240 (further comprising a MEMS array, i.e., a plurality of individual MEMS components or a combination of MEMS elements and electronic components formed on a common substrate). Contacts 244, 245 and 246 on the substrate each connect to electrical elements of the MEMS device 240. Each contact 244, 245 and 246 is electrically continuous with an associated interconnect structure 254, 255 and 256 through respective conductive vias 257, 258 and 259 formed as described above. The interconnect structures 254, 255 and 256 connect the MEMS device 240 through its contacts 244, 245 and 246 to other devices, including devices on the same integrated circuit or die as the MEMS device 240 or subsystems and systems with which the MEMS device 240 operates.

Heat is generated by resistive losses due to current flow within the elements of the MEMS device 240, its contacts 244, 245 and 246, the conductive vias 257, 258 and 259 and the interconnect structures 254, 255 and 256. Mechanical motion (such as opening and closing of a MEMS switch arm in an embodiment where the MEMS device 240 comprises a switch) also generates heat.

A cap 248 enclosing the MEMS device 240 comprises a surface 250 in thermal communication with a heat sink 260 through an intermediate thermal/mechanical connection material layer 262. Heat is withdrawn from the MEMS device 240 through a first thermal path to the heat sink 260 in contact with a surface 250 of the cap 248.

When packaged or assembled as in Figure 12, the heat also flows from the electrically and thermally conductive contacts 244, 245 and 246 through the conductive vias 257, 258 and 259 to the respective interconnect structures 254, 255 and 256. The heat sink 190 withdraws heat from the conductive vias/structures 257-259/254-256.

Each of the dies 120 and 121 in Figures 6-11 and the MEMS device 240 of Figure 12 may comprise a MEMS switch, a MEMS mechanical structure operative in conjunction with electronic components fabricated on the same substrate or a combination of MEMS devices in the form of a MEMS array. An exemplary MEMS switch 299 is fabricated as described below.

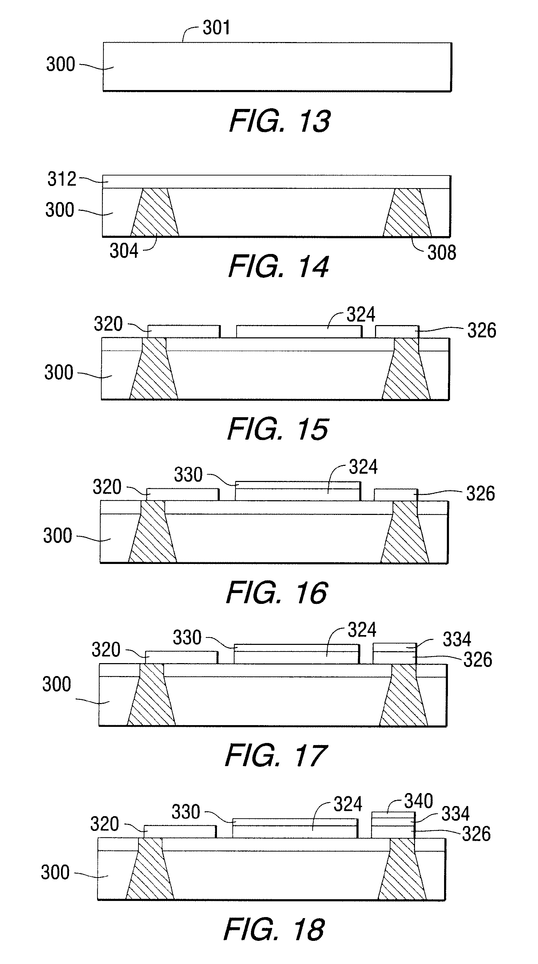

A silicon substrate 300 (see Figure 13) is provided and thru-substrate interconnects (e.g., conductive vias) 304 and 308 are formed according to known techniques.

As illustrated in Figure 14, an SiNx insulating layer 312 is deposited overlying a surface 301 of the substrate 300 followed by a conductive layer overlying the insulating layer 312. Using an appropriately patterned mask (not shown) the conductive layer is patterned to form a drain structure 320, a gate structure 324 and a source structure 326 as illustrated in Figure 15.

In one embodiment the patterned conductive layer comprises a lower sublayer comprising chromium and an upper sublayer comprising gold. A portion of the drain structure 320 overlies and is in electrical communication with the conductive via 304 and a portion of the source structure 326 overlies and is in electrical communication with the conductive via 308. The gate structure 324 is connected to a conductive via or other interconnect structure in a plane other than the cross-sectional plane of Figure 15.

A material layer comprising a silicon dioxide sublayer and an SiNx sublayer is formed and patterned to create an SiO2/SiNx structure 330 overlying the gate structure 324 as illustrated in Figure 16.

As depicted in Figure 17, a height of the source structure 326 is raised to increase the switch contact force and prevent the beam as formed below from contact the gate structure 324 before it contacts the source structure 326. This can be accomplished by depositing additional conductive material 334 on the top surface of the source structure 326 through a patterned layer that prevents unwanted deposition of the conductive material on other structures.

A relatively thick conductive layer 340 is deposited overlying the conductive material 334 as illustrated in Figure 18.

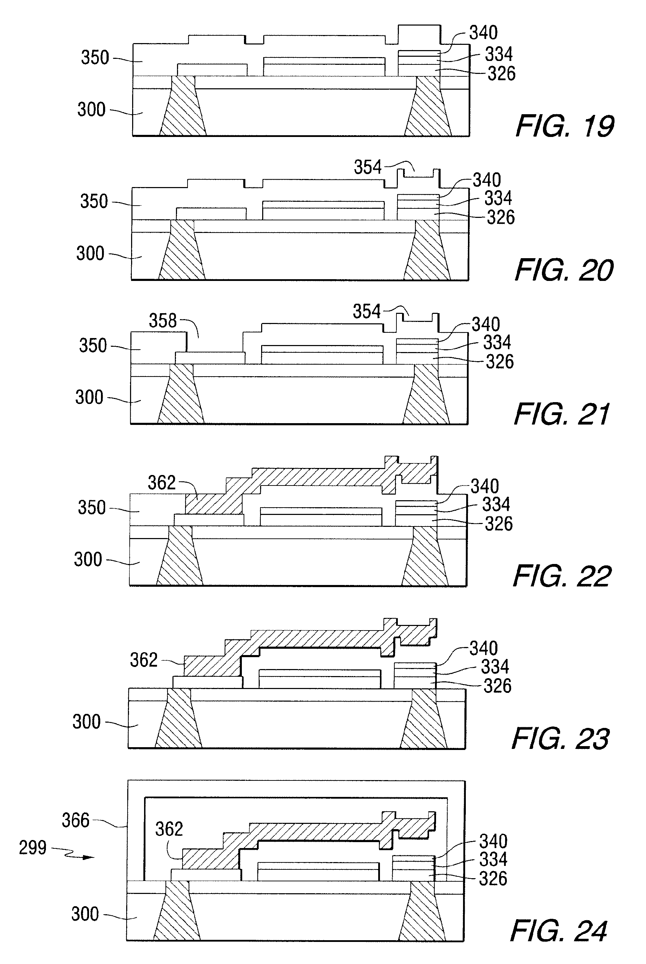

A silicon dioxide layer 350 is deposited (preferably according to a plasma-enhanced chemical vapor deposition process) and the resulting structure illustrated in Figure 19.

Using a suitably patterned mask (not shown) a region of the silicon dioxide layer 350 is etched to form a contact bump opening 354. See Figure 20. Using a suitably patterned mask (not shown) the layer 350 is again etched to form an opening 358 for a beam anchor. See Figure 21.

A conductive structure 362 is then formed (for example by a plating process) over the silicon dioxide layer 350 as shown in Figure 22.

An release etch process removes the silicon dioxide layer 350, resulting in the final structure illustrated in Figure 23.

Fabrication of the switch 299 is completed by enclosing the structural features within a cap 366, which can be formed by known methods including a glass seal, solder, etc. See Figure 24. The switch 299 is suitable for packaging according to the exemplary inventive technique and structures illustrated in Figure 12.

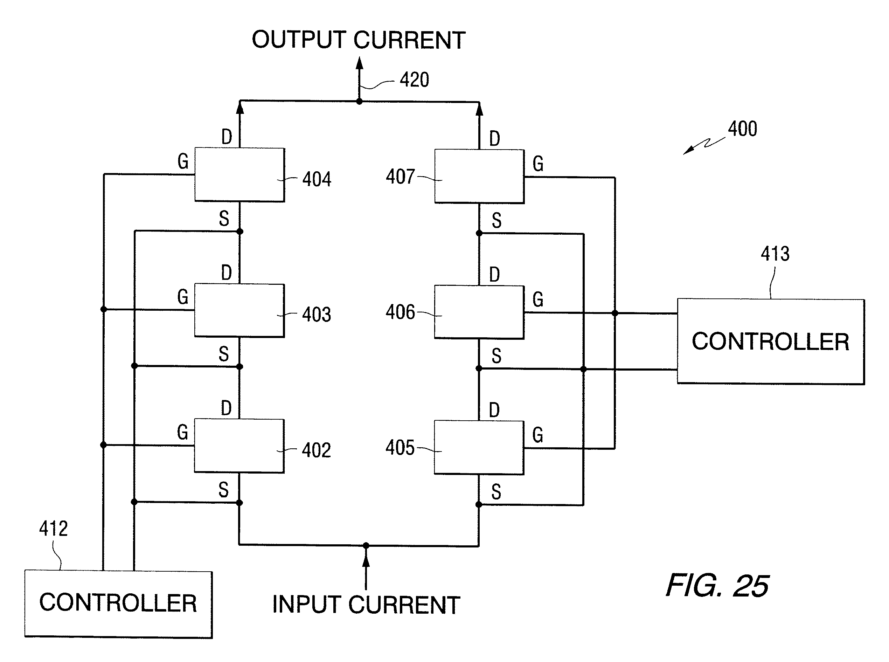

A MEMS array 400 of MEMS switches 402-407 is illustrated in Figure 25. The serially-connected MEMS switches 402-404 are simultaneously controlled to a closed condition by a controller 412. Similarly, the serially-connected MEMS switches 405-407 are simultaneously controlled to a closed condition by a controller 413. Configuring the two switch groups in parallel as illustrated shunts half of an input current through each serially-connected switch group, combining the currents to produce and output current at a terminal 420. The serial switch groups may also be required to satisfy other operating parameters of the application, such as breakdown voltage.

Each of the individual switches 402-407 may be enclosed within a cap, such as the cap 366 of Figure 24. Alternatively, a plurality of the switches 402-407 are enclosed within a single cap. In either case, the array 400 comprises the polyimide layer 100, the heat sink 260, the heat sink 190 and the contact and interconnect structures illustrated in Figure 12. A single heat sink 190 can be used for all of the switches 402-407 or a single heat sink 190 can be used with each switch 402-407. Generally, the former arrangement is preferred.

The fabrication steps and formed structures described herein are generally also applicable to a MEMS device fabricated on the same substrate as semiconductor devices, such as an ASIC (application specific integrated circuit) device. The MEMS device and the ASIC devices are connected during the same process steps, e.g., deposition, masking, patterning.

However, in an application where the semiconductor device comprises components (such as certain passive components) that are not compatible with the processing steps employed to form the MEMS device and its electrical and thermal conduction paths, it may be preferable to form the MEMS device and the semiconductor devices on a separate substrate. Alternatively, to resolve the issues presented by incompatible passive devices, contact pads can be formed on an upper surface of the conductive structures 254-256 of Figure 12 and the passive devices attached (soldered) to the contact pads, i.e., after the MEMS device and its conductive structures have been formed. Certain performance advantages may be realized with the passive devices in proximity to the MEMS device.

Presently, microelectromechanical systems (MEMS) generally refer to micron-scale structures that for example can integrate a multiplicity of diverse elements, e.g., mechanical elements, electromechanical elements, sensors, actuators, and electronics, on a common substrate through micro-fabrication technology. It is contemplated, however, that many techniques and structures presently available in MEMS devices will in a few years be available via nanotechnology-based devices, e.g., structures that may be smaller than 100 nanometers in size. Accordingly, even though exemplary embodiments described throughout this document may refer to MEMS-based devices, it is submitted that the inventive aspects of the embodiments of the present inventions should be broadly construed and should not be limited to micron-sized devices.

This written description uses examples to disclose the embodiments of the inventions, including the best mode, and also to enable any person skilled in the art to make and use the embodiments of the inventions. The patentable scope of the embodiments of the inventions is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. A MEMS structure comprising:
a MEMS device (120/121) having a first surface with one or more contact structures thereon connected to functional elements of the MEMS device (120/121);
a dielectric layer (100) overlying the first surface defining openings (118) therein through which the contact structures are exposed;
a patterned metallization layer (170) comprising conductive material extending from the contact structures through the openings (118) in the dielectric layer (100) and onto a surface of the dielectric layer (100); and
a first heat sink (190) in thermal communication with the metallization layer (170).

2. The MEMS structure of claim 1 further comprising a second surface of the MEMS device opposing the first surface, the second surface in thermal communication with a second heat sink (185/187).

3. The MEMS structure of claim 1 or claim 2, wherein the MEMS device comprises a MEMS switch (299)and wherein the one or more contact structures comprise drain (12), gate (14) and source (16) contacts for controlling the MEMS switch (299) to an open condition or a closed condition.

4. The MEMS structure of any one of the preceding claims, wherein the dielectric layer (100) comprises a polyimide layer.

5. The MEMS structure of any one of the preceding claims, further comprising a thermal interface material (192) disposed between the metallization layer (170) and the first heat sink (190).

6. A MEMS structure comprising:
a MEMS device (240) having a first surface with one or more contact structures (244/245/246) hereon connected to MEMS elements of the MEMS device (240);
a cap (248) enclosing the MEMS elements while exposing the one or more contact structures (244/245/246);
a dielectric layer (100) overlying the first surface defining openings (118) therein through which the contact structures are exposed;
a metallization layer (170) comprising conductive material (174-179) extending from the contact structures (244/245/246) through the openings (118) in the dielectric layer (100) and onto a surface of the dielectric layer (100); and
a first heat sink (260) in thermal communication with the cap (248)

7. The MEMS structure of claim 6 further comprising a second heat sink (190) in thermal communication with the metallization layer .

8. The MEMS structure of claim 6 or claim 7, wherein the MEMS device comprises a plurality of MEMS devices (400) formed on a common substrate.

9. The MEMS structure of any one of claims 6 to 8 wherein the dielectric layer (100) comprises a polyimide layer.

10. A method for forming a MEMS structure, comprising:
providing a substrate (300) having opposing first (301) and second surfaces;
forming an adhesive layer (110) on the first surface (301) of the substrate (300);
forming openings (118) through the substrate (300) and the adhesive layer (110);
affixing a MEMS device (240) to the adhesive layer (110) wherein each contact structure (244-246) on a first surface (301) of the MEMS device (240) is aligned with one of the openings (118);
forming conductive material (174-179) on the second surface and into the openings (118) and further in electrical contact with the contact structures (244-246); and
providing a first heat sink (190) in thermal communication with the conductive material (174-179).
